# EUROPEAN PATENT SPECIFICATION

(11) **EP 0 570 090 B1**
(45) Date of publication and mention of the grant of the patent: **17.10.2001**
(21) Application number: 93300977.1
(22) Date of filing: 11.02.1993
(51) Int. Cl.: H01L 21/28, H01L 29/51, H01L 27/148

(54) **Image sensor and manufacturing method thereof**
Bildsensor und Herstellungsverfahren
Détecteur d'images et son procédé de fabrication

(30) Priority: 11.05.1992 KR 795092
(43) Date of publication of application: 18.11.1993
(73) Proprietor: SAMSUNG ELECTRONICS CO., LTD., Suwon-City, Kyounggi-Do 441-370 (KR)
(72) Inventor: Shin, Jong-Cheol, Suwon, Kyungki-do (KR); Oh, Heung-Kwun, Jangan-ku, Suwon, Kyungki-do (KR)
(74) Representative: Stanley, David William

(56) References cited:
- EP-A- 0 026 953
- EP-A- 0 081 998
- EP-A- 0 214 702
- EP-A- 0 246 555
- PATENT ABSTRACTS OF JAPAN vol. 15, no. 148 (E-1056)15 April 1991

## Description

The present invention relates to solid state image sensors of charge-coupled device (CCD) type and manufacturing methods thereof.

As is already well-known, a solid state image sensor was proposed in a matrix type at the beginning of the 1960's. However, it failed to attain practicability. In the meantime, from the beginning of the 1970's, technology of a large scale integrated circuit (LSI) of a metal oxide semiconductor (MOS) has developed, and a bucket brigade device (BBD) and a CCD have been introduced as charge transfer devices (CTDs). Ever since then, continued study of solid state image sensors has been active.

Generally, the structure of CCD is simple when a plurality of MOS diodes are formed in a uniform arrangement on the surface of a semiconductor substrate. If voltages of inverted direction are applied to a MOS diode, two states are obtained, which are a non-equilibrium state to enlarge a deep depletion region beneath the surface of the semiconductor substrate, and an equilibrium state to accumulate a minority carrier. Thus, if these two states correspond to digital logic levels of "0" and "1," a device having an operational function can be realized. Also, since the number of the minority carriers which are sequentially varied between the non- equilibrium state and the equilibrium state can be used as an analog signal, the above two states enable applications of solid state image sensors, etc.

In a solid state image sensor, the functions of photoelectric converting and accumulating and scanning of charges and the reading-out of electric charges is realized on a single chip. Among solid state image sensors, the CCD type shares an important position because of its good electrical and structural characteristics.

A CCD type solid state image sensor comprises a photo sensing portion composed of a pn junction photodiode or a MOS capacitor, a transfer portion composed of a CCD shift register and an output circuit portion. Here, if light is input to the photo sensing portion, the photo energy is converted into an electrical charge to be accumulated, to then be sent to the transfer portion during a field shift. Next, when a transfer pulse having a different phase is applied to a transfer gate electrode which is regularly arranged on the surface of the semiconductor substrate, through the medium of an insulation layer, the charges are sequentially transferred to below the adjacent electrodes, according to the difference of depth of the depletion layer (potential well) which is formed just beneath the semiconductor substrate surface, by means of the shift of the pulse voltage, to finally be transferred to the output circuit portion.

As described above, the structure of the CCD transfer portion is very simple. However, since the analog signal which is the information represented by a quantity of electric charges should be transferred in the semiconductor substrate, the completeness of its transfer becomes an important factor. The transfer efficiency introduced from a ratio between the initial charge and the transferred charge is an important parameter for determining a characteristic of the CCD.

Generally, to improve the CCD's transfer efficiency, a buried channel CCD (BCCD) in which a channel is formed in the bulk semiconductor just beneath the semiconductor surface has been used since its introduction (Ref, W.H. Kentin Bell Syst. Tech. J. 52, 1009, 1973). However, the CCD requires an electrode structure which shortens the travel time of the minority carrier by shortening the length of the electrode, and then improves an electric field between the adjacent electrodes. Experimental results of the influence of gate electrode length effects on charge transfer efficiency have already been introduced (Ref: John Y. Chen and C.R. Viswanathan, "Barrier lowering in short-channel CCD's," IEEE Trans. Electron Device, ED-29, 1588, 1982).

Reference is also made to EP-A1-0214702 and EP-A1-0026953 (both Philips), the latter of which discloses a manufacturing method which addresses the "weak point" problem discussed below by forming insulating paths in additional manufacturing steps.

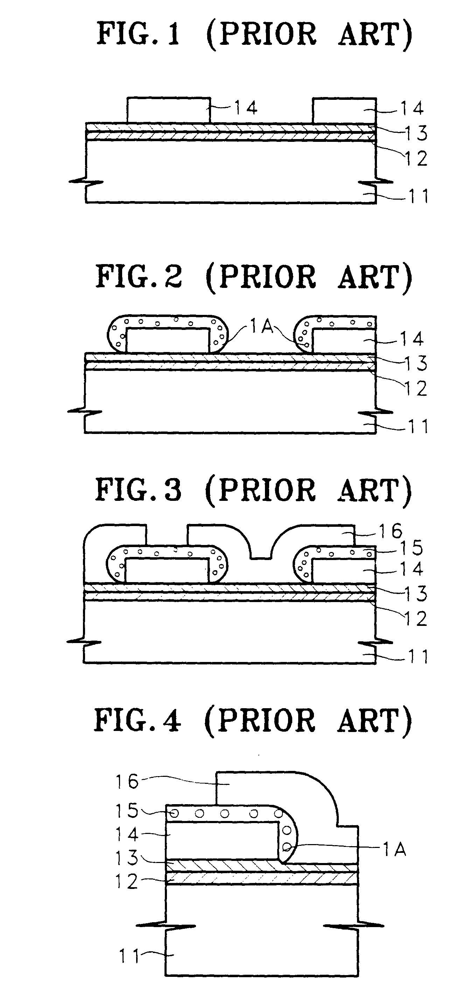

Generally, an overlap gate CCD structure has been widely used, which reduces the electrode length of the CCD and then realizes the high integration of the device. A conventional structure and manufacturing method of an overlap gate CCD will be described below, with reference to the accompanying drawings Figures 1 through 4.

First, as shown in Figure 1, an oxidation film 12 (that is, an oxide film formed by oxidation) and a silicon nitride film 13 are sequentially laminated on a semiconductor substrate 11 as a dielectric layer of a transfer gate electrode. In sequence, after a polycrystalline silicon layer is formed on the overall sides, conventional photolithography and etching processes are performed on the polysilicon layer, to form a first transfer gate electrode 14.

Next, as shown in Figure 2, when the polysilicon comprising first transfer gate electrode 14 is thermally oxidised, an insulation oxidation film 15 is formed with a constant thickness on the surface and the side wall of first transfer gate electrode 14. At this time, formation of insulation oxidation film 15 according to the thermal oxidation method utilizes the oxidation film growth speed difference between silicon nitride film 13 from which the polysilicon layer is removed and exposed, and the polysilicon layer being first transfer gate electrode 14. The thermal oxidation method is a desired insulation oxidation film formation method, which contains, however, a structurally weak portion (portion 1A of Figure 2) to maintain an actually sufficient insulation characteristic.

Next, as shown in Figure 3, after the polysilicon layer has been formed on the overall surfaces of the upper portion in the substrate, a polysilicon layer of a wing-shaped pattern is formed, so that using a conventional photography and etching process, a part of the polycrystalline silicon layer is overlapped with adjacent first transfer gate electrode 14, to form a second transfer gate electrode 16.

In Figure 4, a partial cross-sectional view of the enlarged portion 1A being a structural weak portion of Figure 2 is shown.

The CCD having the conventional overlapped gate structure as described above has a simple manufacturing method and can highly integrate a gate electrode having a short electrode length. However, the conventional CCD contains the following problems.
(1) When insulation oxidation film 15 is formed according to the thermal oxidation process after first transfer gate electrode 14 has been formed, the growth speed of the oxidation film is reduced due to the material characteristic of silicon nitride film 13. For this reason, the edge portion 1A of first transfer gate electrode 14 adjacent to silicon nitride film 13 comes to have a weak structure against a direct leakage current generated by a pinhole, etc. since the insulation oxidation film 15 between the first and the second transfer gate electrodes becomes thinner.
(2) As shown in in detail in Figure 4, when the polycrystalline silicon layer is processed by the photography and the etching process to form first transfer gate electrode 14, a part of silicon nitride film 13 in the lower portion of second transfer gate electrode 16 is over-etched. Accordingly, a thickness difference in silicon nitride film 13 positioned under first transfer gate electrode 14 and second transfer gate electrode 16 occurs. This thickness difference causes a difference in the dielectric capacity due to the thickness difference of the total dielectric layer which exists between two electrode 14 and electrode 16 and semiconductor substrate 11 respectively, to scatter linearity due to the asymmetry of the electric charge transfer below the respective gate electrodes, and change potential below the respective gate electrodes as well. As a result, device characteristics such as transfer efficiency, etc. of the CCD are degraded.
(3) At a dry etching process performed when first transfer gate electrodes 14 are formed and a subsequent thermal oxidation process, the surface of silicon nitride film 13 which is exposed between first transfer gate electrodes 14 is damaged and polluted, thereby degrading the dielectric characteristic of second transfer gate electrode 16.

Preferred embodiments of the present invention aim to provide a semiconductor device and its manufacturing method in which an insulation characteristic between gate electrodes formed on a semiconductor substrate and a dielectric characteristic between the semiconductor substrate and each of the gate electrodes are improved.

Another aim is to provide a semiconductor device in which the insulation characteristic between gate electrodes are greatly improved and which comprises a more reliable gate dielectric film.

According to one aspect of the present invention, there is provided an image sensor comprising: a semiconductor substrate having a first oxidation film and a first nitride film laminated one after the other on the surface of said semiconductor substrate; a plurality of first gate electrodes arranged at predetermined intervals on said first nitride film; an insulation film comprising a second oxidation film formed only on an upper surface and a side wall of each of said first gate electrodes, and a second nitride film which covers an exposed portion of said first oxidation film between said first gate electrodes and which covers said second oxidation film; and a plurality of second gate electrodes which are separately formed on said second nitride film, and which are insulated from adjacent first gate electrodes by said insulation film.

Preferably, said first nitride film has the same thickness as that of said second nitride film.

Preferably, opposite conductivity type of impurities are implanted just below the surface of said semiconductor substrate.

Preferably, said first and second nitride films are silicon nitride films.

Preferably, said second gate electrodes are formed to overlap part of said first gate electrodes.

Preferably, said insulation film is a double film comprising said second oxidation film and said second nitride film.

According to another aspect of the present invention, there is provided a method of manufacturing an image sensor comprising the steps of: laminating on a semiconductor substrate a first oxidation film and a first nitride film one after the other; forming a plurality of first gate electrodes which are arranged on said first nitride film at predetermined intervals; forming a second oxidation film only on the upper surface and the side wall of each of said first gate electrodes; removing said first nitride film which is exposed between said first gate electrodes; forming a second nitride film on said exposed first oxidation film and said second oxidation film; and forming a plurality of second gate electrodes on said second nitride film between said adjacent first gate electrodes.

Preferably, said second oxidation film is formed by a thermal oxidation.

Preferably, removal of said first nitride film is performed by a wet etching process.

A method as above may further comprise the step of, prior to removal of said first nitride film by said wet etching process, removing a part of the upper portion of said first nitride film by a dry etching process.

Preferably, an etching liquid of said wet etching process has a higher etching selection ratio with respect to said first nitride film, than with respect to said second oxidation film.

Preferably, an etching liquid of said wet etching process comprises phosphoric acid.

Preferably, a thickness of said second nitride film is adjusted as desired, considering a dielectric capacity of the lower portion in each of said second gate electrodes.

Preferably, said second nitride film is formed so that a thickness of said second nitride film is the same as that of said first nitride film.

Preferably, a thickness of said first nitride film is within a range of 60 to 2,000Å.

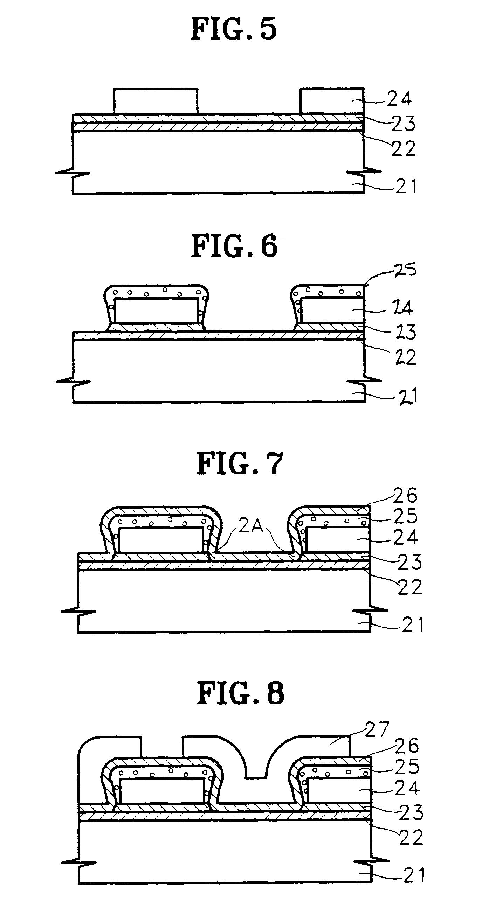

For a better understanding of the invention, and to show how the same may be carried into effect, reference will now be made, by way of example, to Figures 5 to 8 of the accompanying diagrammatic drawings, in which are cross-sectional views to show the formation process of a transfer gate electrode for an image sensor of one embodiment according to the present invention.

The embodiment of Figures 5 to 8 is realized in a CCD structure being an electric charge transfer portion of an image sensor.

In Figure 5, a first oxidation film 22 and a first nitride film 23 are laminated one after the other on a semiconductor substrate 21. Thereafter, a conductive material is coated and formed on the overall surface. Then, a plurality of first gate electrodes 24 are formed by means of a conventional photographic etching technology.

In Figure 5, the semiconductor substrate 21 is mainly composed of a silicon material whose conductivity may be either P-type or N-type. In a BCCD structure, a channel region formed on the semiconductor substrate according to the voltage applied to the gate electrode is formed in a predetermined depth from the surface. Accordingly, in the BCCD structure which improves the transfer efficiency of the generated electric charges, the opposite conductivity type can be formed just below the surface of the semiconductor substrate. As in the case of the CCD performing 2-phase operation, the impurity concentration below the surface of every other gate electrode can be changed so that the electric charge transfer direction is determined.

In Figure 5, a first oxidation film 22 is conventionally a silicon oxidation film having a thickness of 10-2,000Å, and a first nitride film 23 is conventionally a silicon nitride film having a thickness of 60-2,000Å which are deposited by means of a chemical vapor deposition (CVD) method or a plasma enhanced chemical vapor deposition (PECVD) method (10Å = 1 nm).

Subsequently, to form a plurality of first gate electrodes 24, a conventional polycrystalline silicon layer is formed on first nitride film 23. Thereafter, an etching process (e.g. by means of a known dry method) is performed until first nitride film 23 is exposed. At this time, a plurality of first gate electrodes 24 are formed in a predetermined arrangement, while maintaining a predetermined interval. Also, the length of electrode can be desirably adjusted according to the etching pattern, so as to optimize the transfer efficiency of the electric charges. However, in the above dry etching process, first nitride film 23 is over-etched, thereby becoming thinner. Otherwise, first nitride film 23 is easily polluted by surface damage or impurities, etc.

Next, in Figure 6, second oxidation film 25 is formed on the upper surface and the side wall of each of first gate electrodes 24 by a predetermined thickness. Thereafter, only first nitride film 23 which is exposed between first gate electrodes 24, is removed.

In Figure 6, second oxidation film 25 is a thermal oxidation film which is formed by a thermal oxidation process. Here, since first nitride film 23 functions as a oxidation-preventive film, second oxidation film 25 grows on only the upper surface and the side wall of each of first gate electrodes 24 comprising the polycrystalline silicon which is exposed to the atmosphere of thermal oxidation. At this time, at the lower part of the side surface of each of first gate electrodes 24, the silicon oxidation film grows slowly, to thereby be left as a weak portion which degrades the insulation characteristic of second oxidation film 25 used as an insulation film.

Subsequently, first nitride film 23 which is over-etched and polluted is removed by a wet etching process, by means of a phosphoric acid having a high etching selection ratio with respect to first nitride film 23. At this time, to prevent first nitride film 23 which exists in the lower portion of each of first gate electrodes 24 from being over-etched, a part of first nitride film 23 is removed by the dry etching process, to thereafter perform a wet-etching process by the phosphoric acid.

Next, in Figure 7, second nitride film 26 is deposited on the overall surfaces of the final product of the process shown in Figure 6. In Figure 7, second nitride film 26 is a conventional silicon nitride film, and is deposited by the CVD method or the PECVD method, so that the deposition thickness is made to be the same as that of first nitride film 23 which is placed in the lower part of each of first gate electrodes 24. On the other hand, to determine the electric charge transfer direction as in the case of the CCD which performs 2-phase operation, the thickness of second nitride film 26 is made to be deposited thicker than that of first nitride film 23. On the contrary, the former may be formed so as to be thinner than the latter.

On the other hand, in Figure 7, second nitride film 26 is sufficiently deposited at the weak portion 2A where the growth of second oxidation film 25 is incomplete near the lower portion of the side wall in each of first gate electrodes 24, to thereby maintain a slow slope. Accordingly, a subsequent deposition process is easily performed, and the insulation characteristic is reinforced as well.

Referring to Figure 8, a conductive material is deposited on second nitride film 26. Thereafter, second gate electrodes 27 are formed. In Figure 8, a polycrystalline silicon is generally used as the above conductive material. The polycrystalline silicon is patterned so as to overlap with a part of each of first gate electrodes 24, to form second gate electrodes 27. This is desirable in view of the device characteristic. However, as the case may be, the polycrystalline silicon is not overlapped with first gate electrodes 24 or may be formed so as to overlap on only one of first gate electrodes 24.

The semiconductor device as described above may considerably reduce the leakage current density which has been a big problem in conventional semiconductor devices formed with only a thermal oxidation film as the insulation film between the first gate electrode and the second gate electrodes. In the present embodiment of the invention, the non-polluted second nitride film is used as the dielectric film, rather than the first nitride film of the lower portion of each of the second gate electrodes which has been over-etched and damaged during the dry etching process. Accordingly, the dielectric characteristic is improved, thereby preventing the change of the amount of charges which is transferred on the semiconductor substrate, to largely improve the reliability.

On the other hand, using the manufacturing method of the semiconductor device as described above, a semiconductor device having the improved characteristic may be manufactured. Besides, since the length of the gate electrode and the thickness of the dielectric film can be easily adjusted, the electrical and the physical properties of the device can be much improved. Further, manufacturing yield may be considerably increased.

## Claims

1. An image sensor comprising:
a semiconductor substrate (21) having a first oxidation film (22) and a first nitride film (23) laminated one after the other on the surface of said semiconductor substrate (21);
a plurality of first gate electrodes (24) arranged at predetermined intervals on said first nitride film (23);
an insulation film comprising a second oxidation film (25) formed only on an upper surface and a side wall of each of said first gate electrodes (24), and a second nitride film (26) which covers an exposed portion of said first oxidation film (22) between said first gate electrodes (24) and which covers said second oxidation film (25); and
a plurality of second gate electrodes (27) which are separately formed on said second nitride film, and which are insulated from adjacent first gate electrodes (24) by said insulation film.

2. An image sensor according to claim 1, wherein said first nitride film (23) has the same thickness as that of said second nitride film (26).

3. An image sensor according to claim 1 or 2, wherein opposite conductivity type of impurities are implanted just below the surface of said semiconductor substrate (21).

4. An image sensor according to claim 1, 2 or 3, wherein said first and second nitride films (23 and 26) are silicon nitride films.

5. An image sensor according to any of the preceding claims, wherein said second gate electrodes (27) are formed to overlap part of said first gate electrodes (24).

6. A method of manufacturing an image sensor comprising the steps of:
laminating on a semiconductor substrate (21) a first oxidation film (22) and a first nitride film (23) one after the other;
forming a plurality of first gate electrodes (24) which are arranged on said first nitride film (23) at predetermined intervals;
forming a second oxidation film (25) only on the upper surface and the side wall of each of said first gate electrodes (24);
removing said first nitride film (23) which is exposed between said first gate electrodes (24);
forming a second nitride film (26) on said exposed first oxidation film (22) and said second oxidation film (25); and
forming a plurality of second gate electrodes (27) on said second nitride film (26) between said adjacent first gate electrodes (24).

7. A method according to claim 6, wherein said second oxidation film (25) is formed by a thermal oxidation.

8. A method according to claim 6 or 7, wherein removal of said first nitride film (23) is performed by a wet etching process.

9. A method according to claim 8, further comprising the step of, prior to removal of said first nitride film (23) by said wet etching process, removing a part of the upper portion of said first nitride film (23) by a dry etching process.

10. A method according to claim 8 or 9, wherein an etching liquid of said wet etching process has a higher etching selection ratio with respect to said first nitride film (23), than with respect to said second oxidation film (25).

11. A method according to claim 10, wherein an etching liquid of said wet etching process comprises phosphoric acid.

12. A method according to any of claims 6 to 11, wherein a thickness of said second nitride film (26) is adjusted as desired, considering a dielectric capacity of the lower portion in each of said second gate electrodes (27).

13. A method according to any of claims 6 to 12, wherein said second nitride film (26) is formed so that a thickness of said second nitride film (26) is the same as that of said first nitride film (23).

14. A method according to any of claims 6 to 13, wherein a thickness of said first nitride film (23) is within a range of 6 to 200 nm.

## Patentansprüche

1. Bildsensor mit:
einem Halbleitersubstrat (21) mit einem ersten Oxidationsfilm (22) und einem ersten Nitridfilm (23), die nacheinander auf die Oberfläche des Halbleitersubstrats (21) aufgebracht werden,
einer Mehrzahl erster Gate-Elektroden (24), die in vorgegebenen Abständen auf dem ersten Nitridfilm (23) angeordnet sind,
einem Isolierfilm, bestehend aus einem zweiten Oxidationsfilm (25), der lediglich auf einer Oberseite und einer Seitenwand von jeder der ersten Gate-Elektroden (24) ausgebildet ist, und aus einem zweiten Nitridfilm (26), welcher einen freiliegenden Teil des ersten Oxidationsfilms (22) zwischen den ersten Gate-Elektroden (24) bedeckt und welcher den zweiten Oxidationsfilm (25) bedeckt, und
einer Mehrzahl zweiter Gate-Elektroden (27), die separat auf dem zweiten Nitridfilm ausgebildet sind und mit einem Isolierfilm von den benachbarten ersten Gate-Elektroden (24) isoliert sind.

2. Bildsensor nach Anspruch 1, wobei der erste Nitridfilm (23) die selbe Dicke hat wie der zweite Nitridfilm (26).

3. Bildsensor nach Anspruch 1 oder 2, wobei entgegengesetzt leitende Störstellen direkt unter der Oberfläche des Halbleitersubstrats (21) eingepflanzt werden.

4. Bildsensor nach Anspruch 1, 2 oder 3, wobei der erste und der zweite Nitridfilm (23 und 26) Siliciumnitridfilme sind.

5. Bildsensor nach einem der vorangehenden Ansprüche, wobei die zweiten Gate-Elektroden (27) so ausgebildet sind, dass sie einen Teil der ersten Gate-Elektroden (24) überlappen.

6. Verfahren zur Herstellung eines Bildsensors mit den folgenden Schritten:
Aufbringen eines ersten Oxidationsfilms (22) und eines ersten Nitridfilms (23) nacheinander auf ein Halbleitersubstrat (21),
Ausbilden einer Mehrzahl von ersten Gate-Elektroden (24), die in vorgegebenen Abständen auf den ersten Nitridfilm (23) angeordnet sind,
Ausbilden eines zweiten Oxidationsfilms (25) lediglich auf der Oberseite und der Seitenwand von jeder ersten Gate-Elektrode (24),
Entfernen des ersten Nitridfilms (23), der zwischen den ersten Gate-Elektroden (24) frei liegt,
Ausbilden eines zweiten Nitridfilms (26) auf dem freiliegenden ersten Oxidationsfilm (22) und dem zweiten Oxidationsfilm (25), und
Ausbilden einer Mehrzahl zweiter Gate-Elektroden (27) auf dem zweiten Nitridfilm (26) zwischen den benachbarten ersten Gate-Elektroden (24).

7. Verfahren nach Anspruch 6, wobei der zweite Oxidationsfilm (25) durch thermische Oxidation entsteht.

8. Verfahren nach Anspruch 6 oder 7, wobei das Entfernen des ersten Nitridfilms (23) mit einem Nassätzverfahren erfolgt.

9. Verfahren nach Anspruch 8, welches weiterhin vor dem Entfernen des ersten Nitridfilms (23) mittels Nassätzverfahren den Schritt des Entfernens eines Teils des oberen Abschnitts des ersten Nitridfilms (23) mit einem Trockenätzverfahren umfasst.

10. Verfahren nach Anspruch 8 oder 9, wobei eine Ätzflüssigkeit des Nassätzverfahrens ein höheres Ätzauswahlverhältnis in Bezug auf den ersten Nitridfilm (23) als in Bezug auf den zweiten Oxidationsfilm (25) aufweist.

11. Verfahren nach Anspruch 10, wobei eine Ätzflüssigkeit des Nassätzverfahrens Phosphorsäure umfasst.

12. Verfahren nach einem der Ansprüche 6 bis 11, wobei eine Dicke des zweiten Nitridfilms (26) unter Berücksichtigung der dielektrischen Eigenschaften des unteren Teils in jeder der zweiten Gate-Elektroden (27) wie gewünscht eingestellt wird:

13. Verfahren nach einem der Ansprüche 6 bis 12, wobei der zweite Nitridfilm (26) so ausgebildet wird, dass der zweite Nitridfilm (26) die gleiche Dicke aufweist wie der erste Nitridfilm (23).

14. Verfahren nach einem der Ansprüche 6 bis 13, wobei die Dicke des ersten Nitridfilms (23) im Bereich von 6 bis 200 nm liegt.

## Revendications

1. Capteur d'image comprenant :
un substrat semi-conducteur (21) ayant un premier film d'oxydation (22) et un premier film de nitrure (23) superposés l'un après l'autre à la surface dudit substrat semi-conducteur (21) ;
une pluralité de premières électrodes de grille (24) disposées selon des intervalles prédéterminés sur ledit premier film de nitrure (23) ;
un film d'isolation comprenant un second film d'oxydation (25) formé uniquement sur une surface supérieure et une paroi latérale de chacune desdites premières électrodes de grille (24), et un second film de nitrure (26) couvrant une partie exposée dudit premier film d'oxydation (22) entre lesdites premières électrodes de grille (24) et couvrant ledit second film d'oxydation (25) ; et
une pluralité de secondes électrodes de grille (27) formées séparément sur ledit second film de nitrure et isolées des premières électrodes de grille adjacentes (24) par ledit film d'isolation.

2. Capteur d'image selon la revendication 1, dans lequel ledit premier film de nitrure (23) présente la même épaisseur que celle du second film de nitrure (26).

3. Capteur d'image selon la revendication 1 ou 2, dans lequel un type de conductivité opposée des impuretés est implanté juste au-dessous de la surface dudit substrat semi-conducteur (21).

4. Capteur d'image selon la revendication 1, 2 ou 3, dans lequel lesdits premiers et seconds films de nitrure (23) et (26) sont des films de nitrure de silicium.

5. Capteur d'image selon l'une quelconque des revendications précédentes, dans lequel lesdites secondes électrodes de grille (27) sont constituées de manière à recouvrir une partie desdites premières électrodes de grille (24).

6. Procédé de fabrication d'un capteur d'image comprenant les étapes consistant à :
déposer sur un substrat semi-conducteur (21) un premier film d'oxydation (22) et un premier film de nitrure (23) l'un après l'autre ;
former une pluralité de premières électrodes de grille (24) disposées sur le premier film de nitrure (23) selon des intervalles prédéterminés ;
former un second film d'oxydation (25) uniquement sur la surface supérieure et la paroi latérale de chacune des premières électrodes de grille (24) ;
éliminer ledit premier film de nitrure (23) exposé entre lesdites premières électrodes de grille (24) ;
former un second film de nitrure (26) sur ledit premier film d'oxydation (22) et ledit second film d'oxydation (25) exposés ; et
former une pluralité de secondes électrodes de grille (27) sur ledit second film de nitrure (26) entre lesdites premières électrodes de grille adjacentes (24).

7. Procédé selon la revendication 6 dans lequel ledit second film d'oxydation (25) est formé par oxydation thermique.

8. Procédé selon la revendication 6 ou 7 dans lequel l'élimination dudit premier film de nitrure (23) est effectuée par gravure humide.

9. Procédé selon la revendication 8 comprenant en outre l'étape consistant, avant l'élimination dudit premier film de nitrure (23) par ledit procédé de gravure humide, à éliminer une région de la partie supérieure dudit premier film de nitrure (23) par un procédé de gravure à sec.

10. Procédé selon la revendication 8 ou 9 dans lequel un liquide de gravure dudit procédé de gravure humide présente un rapport de sélection de gravure supérieur pour ledit premier film de nitrure (23) par rapport audit second film d'oxydation (25).

11. Procédé selon la revendication 10 dans lequel un liquide de gravure dudit processus de gravure humide comprend l'acide phosphorique.

12. Procédé selon l'une quelconque des revendications 6 à 11 dans lequel une épaisseur dudit second film de nitrure (26) est adaptée à une valeur déterminée, en considérant une capacité diélectrique de la partie inférieure de chacune desdites secondes électrodes de grille (27).

13. Procédé selon l'une quelconque des revendications 6 à 12 dans lequel ledit second film de nitrure (26) est formé de telle sorte qu'une épaisseur dudit second film de nitrure (26) soit identique à celle dudit premier film de nitrure.

14. Procédé selon l'une quelconque des revendications 6 à 13 dans lequel une épaisseur dudit premier film de nitrure (23) est comprise entre 6 nm et 200 nm.
